(19) **Europäisches Patentamt / European Patent Office / Office européen des brevets**

(11) **EP 2 034 813 B1**

(12) **EUROPEAN PATENT SPECIFICATION**

(45) Date of publication and mention
of the grant of the patent:
**01.08.2012 Bulletin 2012/31**

(51) Int Cl.:
*H05K 9/00* (2006.01)     *H01J 17/49* (2012.01)
*H01J 17/16* (2012.01)

(21) Application number: **08163351.3**

(22) Date of filing: **29.08.2008**

(54) **Plasma display apparatus**

Plasmaanzeigevorrichtung

Appareil d'affichage à plasma

(84) Designated Contracting States:
**DE FR GB**

(30) Priority: **06.09.2007 KR 20070090591**

(43) Date of publication of application:
**11.03.2009 Bulletin 2009/11**

(73) Proprietor: **Samsung SDI Co., Ltd.**
**Gyeonggi-do (KR)**

(72) Inventor: **Yeo, Jae-Young**
**Suwon-si**
**Gyeonggi-do (KR)**

(74) Representative: **Walaski, Jan Filip et al**
**Venner Shipley LLP**
**200 Aldersgate**
**London**
**EC1A 4HD (GB)**

(56) References cited:
**US-A1- 2006 061 945    US-A1- 2007 004 253**
**US-A1- 2007 086 149**

**Description**

The present invention relates to a plasma display apparatus, and more particularly, to a plasma display apparatus having a chassis base with an improved structure for effectively reducing the electromagnetic interference (EMI) due to a plasma display panel (PDP).

Plasma display apparatuses are flat display apparatuses which form an image via light emitted from ultraviolet rays generated by a discharge gas injected between facing substrates when a predetermined voltage is applied to electrodes placed on opposite sides of the substrates. The plasma display apparatuses can be manufactured to have a small thickness less than several centimeters, a large screen, and a wide viewing angle compared to other displays. Accordingly, they have been spotlighted as the next generation of display apparatuses.

A conventional plasma display apparatus comprises a plasma display panel (PDP) for displaying an image using plasma generated by a gas discharge, a chassis base for supporting the PDP, and circuit board assemblies for supplying signals to electrodes of the PDP. The circuit board assemblies are mounted on a side of the chassis base, opposite to a side where the PDP is mounted. Conventional plasma display panels having a chassis base are disclosed in US2007/004253, US2006/061945 and US2007/086149.

The chassis base is formed of a metallic material such as aluminum having large mechanical rigidity, and is disposed behind the PDP to fix the circuit board assemblies and reinforce the PDP. The chassis base also performs as a heat sink for dissipating heat generated in the PDP and the circuit board assemblies and acts as a ground for electromagnetic radiation.

The PDP is driven by electrical signals with high frequencies and high voltages and thus generates strong electromagnetic interference. The PDP and the circuit board assemblies generate noise in a low bandwidth (about 30 - 200 MHz), and the operational performance of the PDP is affected by noise with a frequency of 100 MHz. The electromagnetic interference generated by the PDP affects the human body or other electronic devices in the vicinity of the PDP and thus must be controlled to a level less than a standard level.

The chassis base provides the largest ground area in the plasma display apparatus. Therefore, when the electromagnetic interference generated when driving the PDP reaches the chassis base, there is a problem in that the chassis base operates as an antenna that further transmits the electromagnetic interference.

The present invention provides a plasma display apparatus which includes a chassis base with an improved structure that does not act as an antenna for transmitting an electromagnetic interference generated when the plasma display panel operates.

According to an aspect of the present invention, there is provided a plasma display apparatus comprising: a PDP (plasma display panel); and a chassis base comprising a plurality of metallic plates disposed on the same plane behind the PDP, and a connection member connecting sides of the metallic plates and having an electrical insulating property.

The width and the length of the metallic plates may be smaller than a 1/4 of a wavelength λ of a bandwidth in which an electromagnetic field in the plasma display apparatus is maximum.

The wavelength λ may be obtained by the following equation

$$\lambda = \frac{C}{f\sqrt{\epsilon\mu}}$$

where C is the light velocity, ε is the permittivity of a medium, μ is the permeability of the medium, and f is the frequency of a bandwidth in which the electromagnetic field is maximum.

Recesses may be formed along sides of the connection member toward the metallic plates and the metallic plates may be inserted in the recesses.

Protrusions may be formed at sides of the metallic plates toward the connection member, and the protrusions may be inserted in the recesses.

Recesses may be formed along the sides of the metallic plates, and the connection member is inserted in the recesses.

The connection member may comprise a first connection portion engaged with a side of one of the metallic plates and a second connection portion engaged with a side of the other metallic plate and connected to the first connection portion.

A recess may be formed in the first connection portion and a protrusion having a shape corresponding to the recess is formed in the second connection portion so that the recess and the protrusion are engaged with each other and the first connection portion and the second connection portion are connected to each other.

The first connection portion and the second connection portion may be engaged with the sides of the metallic plates by bolts.

Recesses may be formed along sides of the first and second portions toward the metallic plates and the metallic plates may be inserted in the recesses.

According to another aspect of the invention, there is provided a plasma display apparatus comprising a plasma display panel mounted to a chassis base, the chassis base being divided into a plurality of metal plates, each of the plates being insulated from one another.

The above and other aspects and advantages of the present invention will become more apparent by describing in detail exemplary embodiments thereof with reference to the attached drawings in which:

FIG. 1 is an exploded perspective view of a plasma display apparatus according to an embodiment of the present invention;

FIG. 2 is an exploded perspective view of a part of a chassis base of the plasma display apparatus of FIG. 1;

FIG. 3 is a perspective view of a chassis base of a plasma display apparatus according to another embodiment of the present invention;

FIG. 4 is a partial perspective view of a chassis base of a plasma display apparatus according to another embodiment of the present invention;

FIG. 5 is a partial sectional view of a chassis base of a plasma display apparatus according to another embodiment of the present invention;

FIG. 6 is a partial sectional view of a chassis base of a plasma display apparatus according to another embodiment of the present invention;

FIG. 7 is an exploded perspective view of a chassis base of a plasma display apparatus according to another embodiment of the present invention;

FIG. 8 is a sectional view of the chassis base of FIG. 7;

FIG. 9 is a chart illustrating noise measured in a conventional plasma display apparatus; and

FIG. 10 is a chart illustrating noise measured in a plasma display apparatus according to an embodiment of the present invention.

The present invention will now be described more fully with reference to the accompanying drawings, in which exemplary embodiments of the invention are shown.

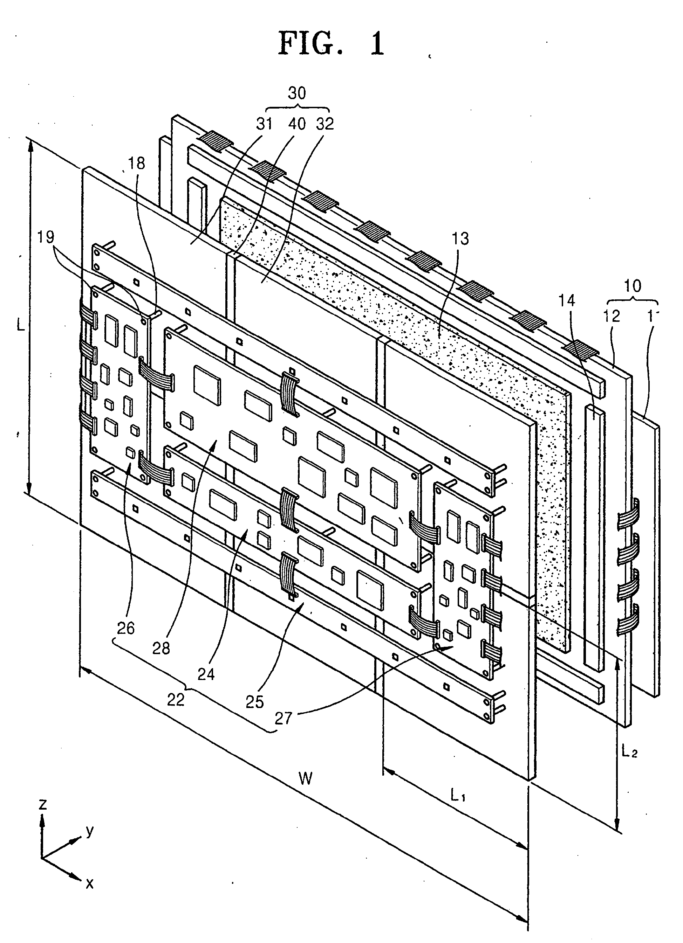

FIG. 1 is an exploded perspective view of a plasma display apparatus according to an embodiment of the present invention. The plasma display apparatus illustrated in FIG. 1 comprises a plasma display panel (PDP) 10 which realizes an image via a gas discharge, and a chassis base 30 which is disposed at a rear side of the PDP 10. In addition, circuit board assemblies 22 which drive the PDP 10 are disposed on the chassis base 30.

The PDP 10 comprises a front substrate 11 and a rear substrate 12 which face each other. A plurality of discharge spaces defined by barrier ribs are formed between the front substrate 11 and the rear substrate 12, and address electrodes and display electrodes (pairs of sustain electrodes and scan electrodes) cross one another in the discharge spaces. When driving signals are applied between the address electrodes and the display electrodes, a gas discharge occurs in the discharge spaces and visible rays are emitted by the gas discharge in a direction toward the front substrate 11 from the discharge spaces so that an image is displayed on the PDP 10.

The chassis base 30 is mounted behind the rear substrate 12 of the PDP 10. The chassis base 30 is formed of a material having large mechanical rigidity in order to support the PDP 10 and the circuit board assembly 22.

A heat-dissipating sheet 13 and a double-sided tape 14 are interposed between the rear side of the PDP 10 and the front side of the chassis base 30. The heat-dissipating sheet 13 conducts and disperses heat generated in the PDP 10 due to a gas discharge in a plane direction (x-z plane direction). The heat-dissipating sheet 13 may be formed of an acryl-based heat-dissipating material having high thermal conductivity, a graphite-based heat-dissipating material, a metal-based heat-dissipating material, or carbon nanotube-based heat-dissipating material.

In addition, since the double-sided tape 14 is used to attach the PDP 10 and the chassis base 30 to each other, the heat-dissipating sheet 13 may be closely attached to the rear side of the PDP 10 and the rear side of the chassis base 30.

The circuit board assemblies 22 are mounted in a boss 18 of the chassis base 30 using a set screw 19. The circuit board assemblies 22 includes an image processing/control board assembly 24, an address buffer board assembly 25, a scan driving board assembly 26, a sustain driving board assembly 27, and a switching mode power supply (SMPS) board assembly 28.

The image processing/control board assembly 24 receives an external image signal to generate a control signal for driving address electrodes, scan electrodes, or sustain electrodes. The control signal is applied to the address buffer board assembly 25, the scan driving board assembly 26, or the sustain driving board assembly 27. The address buffer board assembly 25 generates an address pulse signal that is applied to the address electrodes of the PDP 10. The scan driving board assembly 26 generates a scan pulse signal that is applied to the scan addresses of the PDP 10. The sustain driving board assembly 27 generates a sustain pulse signal that is applied to the sustain electrodes of the PDP 10. The SMPS board assembly 28 supplies power for driving the PDP 10.

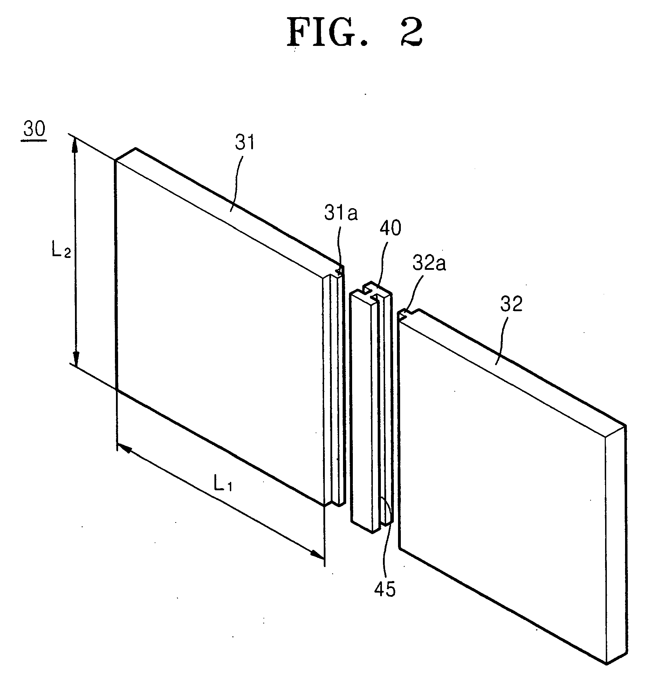

FIG. 2 is an exploded perspective view of a part of the chassis base 30 of the plasma display apparatus of FIG. 1. The chassis base 30 comprises a plurality of metallic plates 31 and 32 disposed on the same plane behind the PDP 10, and a connection member 40 having an electrical insulating property. Sides of the metallic plates 31 and 32 are connected to one another by the connection member 40.

As illustrated in FIG. 2, recesses 45 are formed in sides of the connection member 40 toward the metallic plates 31 and 32. The metallic plates 31 and 32 are inserted in the recesses 45 of the connection member 40 so that the adjacent metallic plates 31 and 32 can be connected to each other.

The metallic plates 31 and 32 comprise protrusions 31a and 32a that are inserted in the recesses 45 so that the metallic plates 31 and 32 and the connection member 40 can be firmly combined with one another.

As illustrated in FIGS. 1 and 2, since the chassis base 30 includes the plurality of metallic plates 31 and 32, an electromagnetic field generated in the PDP 10 and transmitted by the chassis base 30 can be minimized. Width $L_1$ and length $L_2$ of the metallic plates 31 and 32 are smaller than 1/4 of a wavelength $\lambda$ of a bandwidth in which the electromagnetic field generated in the PDP 10 is maximum.

It is known that an antenna has maximum efficiency when the length of the antenna is 1/4 of a wavelength $\lambda$ of a bandwidth in which an electromagnetic field is generated. In the prior art, since the length of a chassis base is larger than 1/4 of a wavelength $\lambda$ of a bandwidth in which an electromagnetic field is generated, the chassis base functions as an antenna and the plasma display apparatus is highly sensitive to EMI in a low bandwidth. However, in the present embodiment, since the chassis base 30 includes the plurality of the metallic plates 31 and 32 having the width $L_1$ and the length $L_2$ smaller than a 1/4 of a wavelength $\lambda$ of a bandwidth in which an electromagnetic field is generated, the chassis base 30 does not function as an antenna, and thus the EMI can be reduced.

Upon measuring the intensity of sustain noise generated when the sustain driving board assembly 27 supplies a sustain pulse signal, the electromagnetic field generated in the PDP 10 is maximum generally at a frequency of 80 MHz.

When the frequency of a bandwidth where the electromagnetic field is maximum is f(Hz) and the wavelength of the electromagnetic field is $\lambda$(m), the speed v(m/s) of the electromagnetic field is obtained according to equation 1.

$$v = f \times \lambda$$

$$\ldots \; (1)$$

In addition, when the light velocity is C(m/s), the permittivity of a medium is $\varepsilon$, and the permeability of the medium is $\mu$, the speed v of EMI is obtained by equation 2.

$$v = \frac{C}{\sqrt{\varepsilon\mu}}$$

$$\ldots \; (2)$$

Accordingly, by combining equations (1) and (2), the wavelength $\lambda$(m) at which the electromagnetic field is maximum, is given by equation 3.

$$\lambda = \frac{C}{f\sqrt{\epsilon\mu}}$$

$$\cdots (3)$$

When the light velocity $C = 3 \times 10^8$ m/s, $\epsilon\mu = 4$, and $f = 80$ MHz are substituted in equation (3), the wavelength $\lambda$(m) is obtained by equation 4.

$$\lambda = \frac{(3 \times 10^8)}{(80 \times 10^6)\sqrt{4}} = 1.875 \, (\text{m})$$

$$\cdots (4)$$

$$\frac{\lambda}{4} = 468.75 \, (\text{mm})$$

$$\cdots (5)$$

Therefore, the width $L_1$ and the length $L_2$ of the metallic plates 31 and 32 should be smaller than 468.75 mm.

If the total width W and the total length L of the chassis base 30 are respectively 1,155 mm and 671 mm, the width $L_1$ of the metallic plates 31 and 32 may be smaller than 385 mm, a value that is obtained by dividing the entire width W by three parts, and the length $L_2$ of the metallic plates 31 and 32 may be smaller than 335.5 mm, a value that is obtained by dividing the entire length L by two. Thus, the number of metallic plates of the chassis base 30 is 6, as illustrated in FIG. 1, and the width $L_1$ and the length $L_2$ of each of the metallic plates 31 and 32 are smaller than ¼ of a wavelength $\lambda$ of a bandwidth in which the electromagnetic field is maximum.

In a conventional plasma display apparatus, only one chassis base according to the size of a PDP is used. Thus, the chassis base functions as an antenna and a strong electromagnetic field is generated in the PDP.

In the present invention, however, the metallic plates 31 and 32 of the chassis base 30 illustrated in FIG. 1 are insulated from each other by the connection member 40. Thus, the electromagnetic field generated by the PDP 10 is reduced to half in the vertical direction and to 1/3 in the horizontal direction by the chassis base 30 divided into the plurality of the metallic plates 31 and 32.

In addition, the metallic plates 31 and 32 do not function as an antenna for transmitting the electromagnetic field, and thus the EMI can be remarkably reduced.

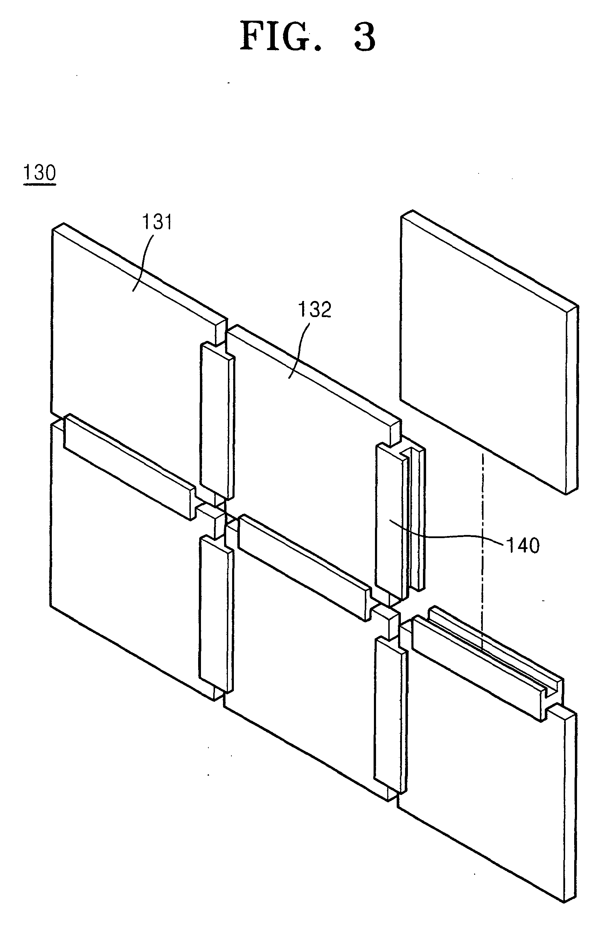

FIG. 3 is a perspective view of a chassis base of a plasma display apparatus according to another embodiment of the present invention. The chassis base 130 of FIG. 3 comprises a plurality of metallic plates 131 and 132 disposed on the same plane behind the PDP, and a connection member 140 connecting sides of the metallic plates 131 and 132 and having an electrical insulating property.

Recesses 145 are formed in sides of the connection member 140 toward the metallic plates 131 and 132, and the sides of the metallic plates 131 and 132 are directly inserted in the recesses 145. In FIG. 2, protrusions are provided at sides of the metallic plates and are inserted in the recesses. In the present embodiment, the widths of the recesses 145 correspond to the thicknesses of the metallic plates 131 and 132 and the sides of the metallic plates 131 and 132 are inserted in the recesses 145 so that the metallic plates 131 and 132 and the connection member 140 can be connected to one another.

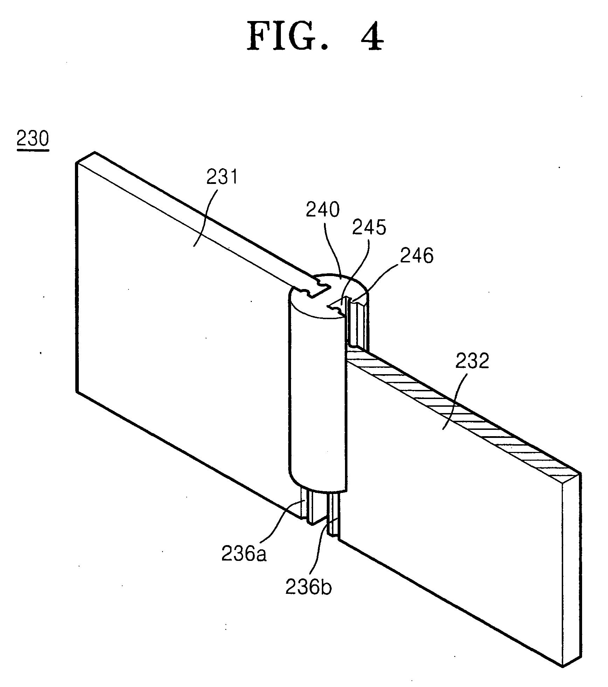

FIG. 4 is a partial perspective view of a chassis base of a plasma display apparatus according to another embodiment of the present invention. The chassis base 230 of FIG. 4 comprises a plurality of metallic plates 231 and 232 disposed on the same plane behind the PDP, and a connection member 240 connecting sides of the metallic plates 231 and 232 and having an electrical insulating property.

Recesses 245 are formed in sides of the connection member 240 toward the metallic plates 231 and 232, and protrusions 246 are formed in the recesses 245 and extend along the sides of the connection member 240.

Edges of the metallic plates 231 and 232 are inserted in the recesses 245 of the connection member 240. Grooves 236a and 236b having shapes corresponding to the protrusions 246 are formed in the front and back of the edges of the metallic plates 231 and 232 inserted in the recesses 245.

When the edges of the metallic plates 231 and 232 are combined with the recesses 245 in the above configuration, the grooves 236a and 236b and the protrusions 246 are engaged and combined with one another so that the metallic plates 231 and 232 and the connection member 240 can be assembled firmly and the entire rigidity of the chassis base 230 can be increased.

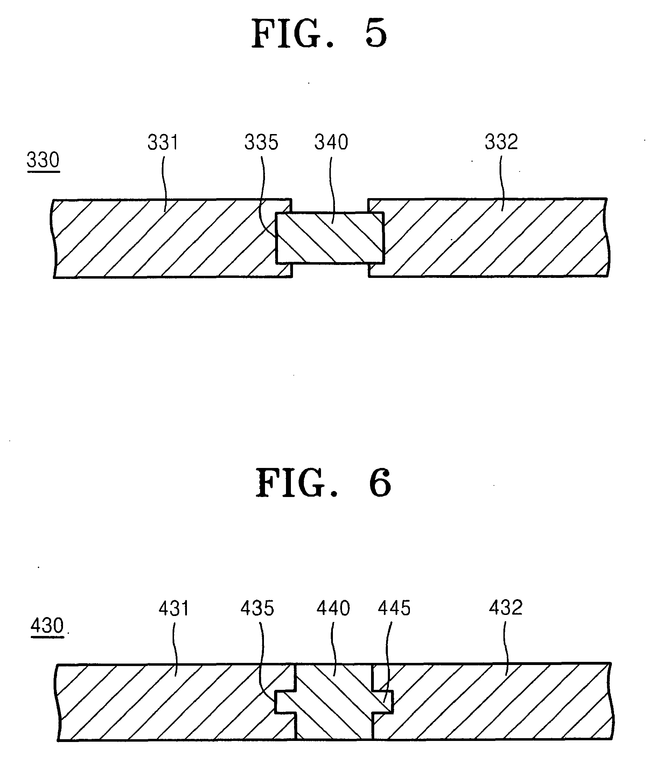

FIG. 5 is a partial sectional view of a chassis base of a plasma display apparatus according to another embodiment of the present invention. A chassis base 330 illustrated in FIG. 5 disposed behind a PDP (not shown) comprises a plurality of metallic plates 331 and 332 disposed on the same plane, and a connection member 340 connecting sides of the metallic plates 331 and 332 and having an electrical insulating property.

Recesses 335 are formed in sides of the metallic plates 331 and 332 toward the connection member 340 and extend along the metallic plates 331 and 332. Side edges of the connection member 340 are inserted in the recesses 335 so that the metallic plates 331 and 332 and the connection member 340 can be connected to one another.

FIG. 6 is a partial sectional view of a chassis base of a plasma display apparatus according to another embodiment of the present invention. A chassis base 430 illustrated in FIG. 6 disposed behind a PDP (not shown) comprises a plurality of metallic plates 431 and 432 disposed on the same plane behind the PDP, and a connection member 440 connecting sides of the metallic plates 431 and 432 and having an electrical insulating property.

Recesses 435 are formed in sides of the metallic plates 431 and 432 toward the connection member 440 and extend along the metallic plates 431 and 432. Protrusions 445 are formed in sides of the connection member 440 toward the metallic plates 431 and 432 and extend along the sides of the connection member 440. The protrusions 445 of the connection member 440 are combined with the recesses 435 of the connection member 440 so that the connection member 440 and the metallic plates 431 and 432 can be stably assembled.

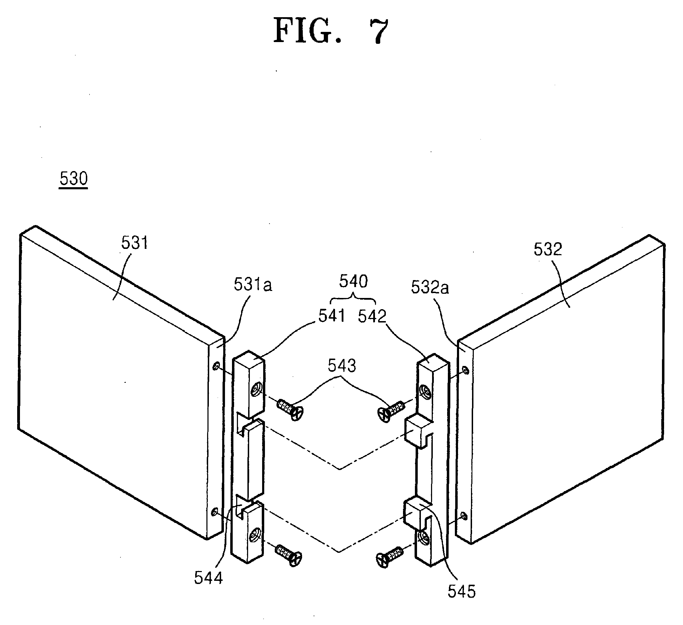

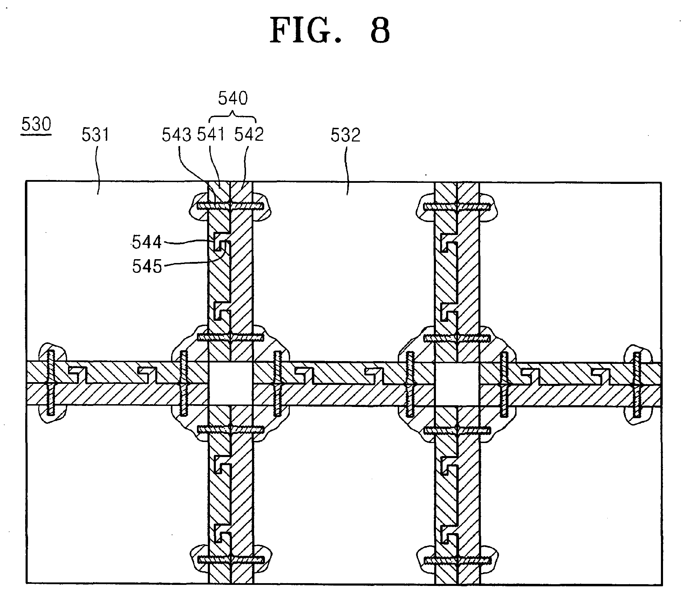

FIG. 7 is an exploded perspective view of a chassis base of a plasma display apparatus according to another embodiment of the present invention, and FIG. 8 is a sectional view of the chassis base of FIG. 7.

The chassis base 530 illustrated in FIGS. 7 and 8 comprises a plurality of metallic plates 531 and 532 disposed on the same plane behind a PDP (not shown), and a connection member 540 connecting sides of the metallic plates 531 and 532 and having an electrical insulating property.

The connection member 540 in the present embodiment comprises a first connection portion 541 combined with one side metallic plate 531 and a second connection portion 542 combined with the other side metallic plate 532, unlike in the above embodiments in which one connection member connects two metallic plates. The first connection portion 541 is engaged with a side 531a of the one side metallic plate 531 and the second connection portion 542 is engaged with a side 532a of the other side metallic plate 532 opposing the one side metallic plate 531.

The first connection portion 541 and the second connection portion 542 may be engaged with the metallic plates 531 and 532 by a bolt 53. In addition, a recess 544 is formed in the connection portion 541, and a protrusion 545 having a shape corresponding to the recess 544 is formed in the second connection portion 542. Due to the above configuration, the recess 544 and the protrusion 545 are engaged with each other so that the first connection portion 541 and the second connection portion 542 can be connected to each other and a firm assembly state can be maintained.

The first connection portion 541 and the second connection portion 542 are engaged with the metallic plates 531 and 532 using the bolt 53, but the present invention is not limited to this. The first connection portion 541 and the second connection portion 542 may be connected to each other by forming a recess and a protrusion in sides of the metallic plates 531 and 532 and the first and second connection portions 541 and 542 and by combining them, like in FIGS. 2 through 6. In addition, the first connection portion 541 and the second connection portion 542 may be combined with the metallic plates 531 and 532 using an adhesive.

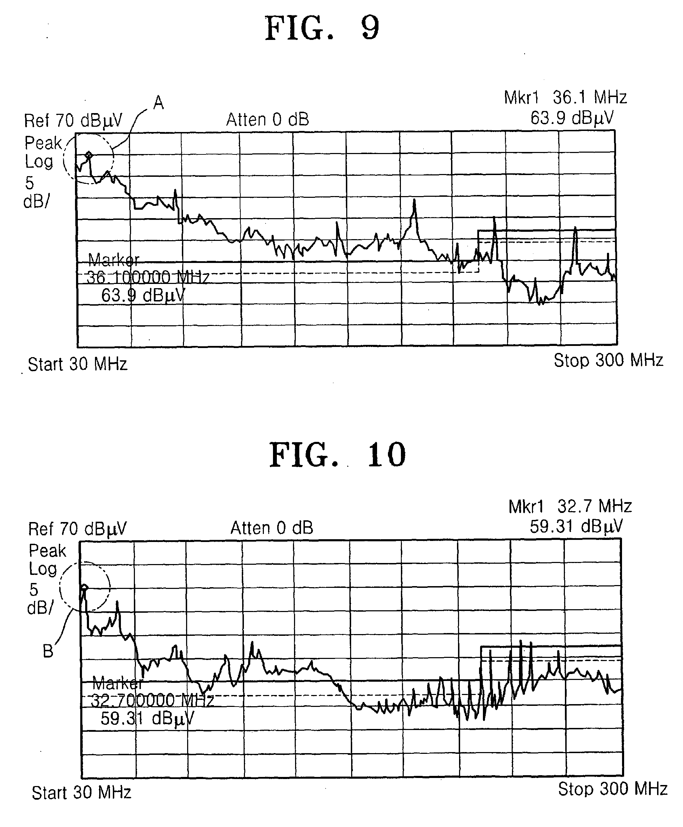

FIG. 9 is a chart illustrating noise measured in a conventional plasma display apparatus, and FIG. 10 is a chart illustrating noise measured in a plasma display apparatus according to an embodiment of the present invention.

Referring to FIG. 9, the width and length of the chassis base of the conventional plasma display apparatus are 1,155 mm and 671 mm, respectively.

As shown in FIG. 9, noise has a maximum value of 63.9 dB in portion A at a frequency of 36.1 MHz.

FIG. 10 shows noise measured in a plasma display apparatus having a chassis base divided into a plurality of metallic plates electrically insulated by a connection member, according to an embodiment of the present invention. The width and length of the metallic plates are 385 mm and 223 mm, respectively.

As shown in FIG. 10, noise has a maximum value of 59.31 dB in portion B at a frequency of 32.7 MHz. Thus, it can be concluded that maximum electromagnetic radiation is reduced due to the improved structure of the chassis base that does not function as an antenna.

While the present invention has been particularly shown and described with reference to exemplary embodiments thereof, it will be understood by those of ordinary skill in the art that various changes in form and details may be made therein without departing from the scope of the present invention as defined by the following claims.

**Claims**

1.  A plasma display apparatus comprising:

    a plasma display panel PDP; and
    a chassis base (30, 130, 230, 330, 430, 530) comprising a plurality of metallic plates (31, 32, 131, 132, 231, 232, 331, 332, 431, 432, 531, 532) disposed in the same plane behind the PDP, and a connection member (40, 140, 240, 340, 440, 540) connecting sides of the metallic plates and having an electrical insulating property.

2.  The plasma display apparatus of claim 1, wherein the width and the length of the metallic plates are smaller than a 1/4 of a wavelength $\lambda$ of a bandwidth in which an electromagnetic field in the plasma display apparatus is maximum.

3.  The plasma display apparatus of claim 2, wherein the wavelength $\lambda$. is obtained by the following equation

$$\lambda = \frac{C}{f \sqrt{\epsilon \mu}}$$

    where C is the light velocity, $\epsilon$ is the permittivity of a medium, $\mu$ is the permeability of the medium, and f is the frequency of a bandwidth in which the electromagnetic field is maximum.

4.  The plasma display apparatus of any one of claims 1 to 3, wherein recesses (45, 145, 245) are formed along sides of the connection member toward the metallic plates and the metallic plates are inserted in the recesses.

5.  The plasma display apparatus of claim 4, wherein protrusions are formed at sides of the metallic plates toward the connection member, and the protrusions are inserted in the recesses.

6.  The plasma display apparatus of any one of claims 1 to 3, wherein recesses (335, 435) are formed along the sides of the metallic plates, and the connection member is inserted in the recesses.

7.  The plasma display apparatus of any one of claims 1 to 3, wherein the connection member comprises a first connection portion (541) engaged with a side of one of the metallic plates and a second connection portion (542) engaged with a side of the other metallic plate and connected to the first connection portion.

8.  The plasma display apparatus of claim 7, wherein a recess is formed in the first connection portion and a protrusion having a shape corresponding to the recess is formed in the second connection portion so that the recess and the protrusion are engaged with each other and the first connection portion and the second connection portion are connected to each other.

9.  The plasma display apparatus of claim 7 or 8, wherein the first connection portion and the second connection portion are engaged with the sides of the metallic plates by bolts.

10. The plasma display apparatus of claim 7 or 8, wherein recesses are formed along sides of the first and second portions toward the metallic plates and the metallic plates are inserted in the recesses.

**Patentansprüche**

1.  Plasmaanzeigevorrichtung, umfassend:

eine Plasmaanzeigetafel PDP; und

eine Chassis-Grundplatte (30, 130, 230, 330, 430, 530) umfassend eine Vielzahl von metallischen Platten (31, 32, 131, 132, 231, 232, 331, 332, 431, 432, 531, 532), die in derselben Ebene hinter der PDP angeordnet sind, sowie ein Verbindungsglied (40, 140, 240, 340, 440, 540), das Seiten der metallischen Platten verbindet und ein elektrisches Isoliervermögen aufweist.

2. Plasmaanzeigevorrichtung nach Anspruch 1, wobei die Breite und die Länge der metallischen Platten geringer sind als ¼ einer Wellenlänge λ einer Bandbreite, in der ein elektromagnetisches Feld in der Plasmaanzeigevorrichtung maximal ist.

3. Plasmaanzeigevorrichtung nach Anspruch 2, wobei die Wellenlänge λ mit der folgenden Gleichung erhalten wird:

$$\lambda = \frac{C}{f\sqrt{\epsilon\mu}}$$

wobei C die Lichtgeschwindigkeit, ε die Permittivität eines Mediums, μ die Durchlässigkeit des Mediums und f die Frequenz einer Bandbreite ist, in der das elektromagnetische Feld maximal ist.

4. Plasmaanzeigevorrichtung nach einem der Ansprüche 1 bis 3, wobei entlang Seiten des Verbindungsglieds Rücksprünge (45, 145, 245) zu den metallischen Platten hin ausgebildet sind und die metallischen Platten in die Rücksprünge eingesetzt sind.

5. Plasmaanzeigevorrichtung nach Anspruch 4, wobei an Seiten der metallischen Platten Vorsprünge zu dem Verbindungsglied hin ausgebildet sind und die Vorsprünge in die Rücksprünge eingesetzt sind.

6. Plasmaanzeigevorrichtung nach einem der Ansprüche 1 bis 3, wobei entlang der Seiten der metallischen Platten Rücksprünge (335, 435) ausgebildet sind und das Verbindungsglied in die Rücksprünge eingesetzt ist.

7. Plasmaanzeigevorrichtung nach einem der Ansprüche 1 bis 3, wobei das Verbindungsglied einen ersten Verbindungsabschnitt (541), der sich mit einer Seite einer der metallischen Platten in Eingriff befindet, und einen zweiten Verbindungsabschnitt (542), der sich mit einer Seite der anderen metallischen Platte in Eingriff befindet und mit dem ersten Verbindungsabschnitt verbunden ist, umfasst.

8. Plasmaanzeigevorrichtung nach Anspruch 7, wobei in dem ersten Verbindungsabschnitt ein Rücksprung ausgebildet ist und in dem zweiten Verbindungsabschnitt ein Vorsprung mit einer dem Rücksprung entsprechenden Form ausgebildet ist, so dass sich der Rücksprung und der Vorsprung miteinander in Eingriff befinden und der erste Verbindungsabschnitt und der zweite Verbindungsabschnitt miteinander verbunden sind.

9. Plasmaanzeigevorrichtung nach Anspruch 7 oder 8, wobei der erste Verbindungsabschnitt und der zweite Verbindungsabschnitt mit den Seiten der metallischen Platten mittels Bolzen in Eingriff sind.

10. Plasmaanzeigevorrichtung nach Anspruch 7 oder 8, wobei entlang Seiten der ersten und zweiten Abschnitte Rücksprünge zu den metallischen Platten hin ausgebildet sind und die metallischen Platten in die Rücksprünge eingesetzt sind.

**Revendications**

1. Équipement d'affichage à plasma comprenant :

un écran à plasma (PDP) ; et
une base de châssis (30, 130, 230, 330, 430, 530) comprenant une pluralité de plaques métalliques (31, 32, 131, 132, 231, 232, 331, 332, 431, 432, 531, 532) disposées dans le même plan derrière le PDP, et un organe de liaison (40, 140, 240, 340, 440, 540) liant des côtés des plaques métalliques et ayant une propriété d'isolation électrique.

**2.** Équipement d'affichage à plasma selon la revendication 1, dans lequel la largeur et la longueur des plaques métalliques sont plus petites que 1/4 de la longueur d'onde λ d'une largeur de bande dans laquelle est maximal un champ électromagnétique dans l'équipement d'affichage à plasma.

**3.** Équipement d'affichage à plasma selon la revendication 2, dans lequel la longueur d'onde λ s'obtient à l'aide de l'équation suivante :

$$\lambda \;=\; \frac{C}{f\sqrt{\varepsilon\mu}}$$

où C est la vitesse de la lumière, ε est la permittivité d'un milieu, μ est la perméabilité du milieu, et f est la fréquence d'une largeur de bande dans laquelle le champ électromagnétique est maximal.

**4.** Équipement d'affichage à plasma selon l'une quelconque des revendications 1 à 3, dans lequel des évidements (45, 145, 245) sont formés le long des côtés de l'organe de liaison en direction des plaques métalliques et dans lequel les plaques métalliques sont insérées dans les évidements.

**5.** Équipement d'affichage à plasma selon la revendication 4, dans lequel des protubérances sont formées au niveau des côtés des plaques métalliques en direction de l'organe de liaison, et dans lequel les protubérances sont insérées dans les évidements.

**6.** Équipement d'affichage à plasma selon l'une quelconque des revendications 1 à 3, dans lequel des évidements (335, 435) sont formés le long des côtés des plaques métalliques, et dans lequel l'organe de liaison est inséré dans les évidements.

**7.** Équipement d'affichage à plasma selon l'une quelconque des revendications 1 à 3, dans lequel l'organe de liaison comprend une première partie (541) de liaison en prise avec un côté d'une des plaques métalliques et une seconde partie (542) de liaison en prise avec un côté de l'autre plaque métallique et liée à la première partie de liaison.

**8.** Équipement d'affichage à plasma selon la revendication 7, dans lequel un évidement est formé dans la première partie de liaison et une protubérance ayant une forme correspondant à l'évidement est formée dans la seconde partie de liaison de sorte que l'évidement et la protubérance s'engagent l'un dans l'autre et que la première partie de liaison et la seconde partie de liaison sont liées l'une à l'autre.

**9.** Équipement d'affichage à plasma selon la revendication 7 ou 8, dans lequel la première partie de liaison et la seconde partie de liaison sont en prise avec les côtés des plaques métalliques à l'aide de vis.

**10.** Équipement d'affichage à plasma selon la revendication 7 ou 8, dans lequel des évidements sont formés le long des côtés des première et seconde parties en direction des plaques métalliques et dans lequel les plaques métalliques sont insérées dans les évidements.

# FIG. 1

# FIG. 2

# FIG. 3

130

131

132

140

# FIG. 4

# FIG. 5

# FIG. 6

# FIG. 7

# FIG. 8

# FIG. 9

Ref 70 dBμV — A
Atten 0 dB
Mkr1 36.1 MHz
63.9 dBμV

Peak
Log
5
dB/

Marker
36.100000 MHz
63.9 dBμV

Start 30 MHz
Stop 300 MHz

# FIG. 10

Ref 70 dBμV
Atten 0 dB
Mkr1 32.7 MHz
59.31 dBμV

Peak
Log
5
dB/

B

Marker
32.700000 MHz
59.31 dBμV

Start 30 MHz
Stop 300 MHz

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007004253 A
- US 2006061945 A
- US 2007086149 A